# DEMANDE DE BREVET EUROPEEN

(11) **EP 4 482 272 A1**
(43) Date de publication de la demande: **25.12.2024**
(21) Numéro de dépôt: 23305979.9
(22) Date de dépôt: 21.06.2023
(51) Int. Cl.: H05K 9/00

(54) **CARTE ÉLECTRONIQUE EQUIPÉE D'UN DISPOSITIF DE DISSIPATION THERMIQUE ET APPAREIL COMPRENANT UNE TELLE CARTE ÉLECTRONIQUE**

(71) Demandeur: BULL SAS, 78340 Les Clayes-Sous-Bois (FR)
(72) Inventeur: TENEZE, Bernard, 13640 La Roque-d'Anthéron (FR)
(74) Mandataire: IPAZ

(57) **Abrégé**

L'invention concerne une carte électronique (200) comprenant :
- un support (102),
- au moins un composant électronique (104) monté sur ledit support (102),
- une couche de protection (110), montée sur ledit support (102), recouvrant ledit composant électronique (104) à une distance non nulle dudit composant électronique (104), et
- un dispositif de dissipation thermique pour ledit composant électronique (104) comprenant une pièce de liaison thermique (202) métallique vissée dans ladite couche de protection (110), traversant ladite couche de protection (110) et venant au contact dudit composant électronique (104), de sorte à créer une liaison thermique entre ledit composant électronique (104) et ladite couche de protection (110).
Elle concerne également un appareil électronique comprenant une telle carte électronique.

## Description

La présente invention concerne une carte électronique équipée d'un dispositif de dissipation thermique pour au moins un composant électronique de ladite carte électronique. Elle concerne également un appareil comprenant une telle carte électronique.

Le domaine de l'invention est de manière générale le domaine de la dissipation thermique de composants montés sur un circuit imprimé, et en particulier de composants électroniques soudés sur un circuit imprimé utilisé dans des applications en radiofréquence.

### État de la technique

En fonctionnement, un composant électronique monté sur un circuit imprimé, par exemple par soudage, dissipe de l'énergie sous forme de chaleur. Cette chaleur doit être évacuée pour que le composant n'atteigne jamais la température au-delà de laquelle il cesse de fonctionner. Pour évacuer la chaleur, il est connu d'utiliser une plaque de dissipation thermique en contact avec le composant électronique pour dissiper cette chaleur.

Dans certains cas, le composant électronique est recouvert d'un blindage pour des raisons d'isolement radiofréquence. La paque de dissipation se trouve alors à l'extérieur du blindage, et ne peut pas assurer la dissipation thermique. Dans ces cas, la solution généralement utilisée consiste à établir une liaison thermique entre le composant et le blindage électromagnétique. Or, les tolérances de fabrication concernant la hauteur du composant monté sur le circuit imprimé, la position relative du blindage, et les hauteurs des joints de soudure du composant ne permettent pas d'utiliser une pièce métallique de dimension prédéterminée pour réaliser cette liaison thermique.

Pour parer à ces difficultés, la solution actuellement connue est d'utiliser une mousse thermique disposée entre le composant électronique et le blindage : cette mousse permet d'absorber l'ensemble des tolérances de fabrication car ladite mousse est compressible jusqu'à un certain point.

Le principal inconvénient de cette solution est la mauvaise conduction thermique de la mousse. La dissipation thermique du composant électronique s'en trouve particulièrement réduite.

Un but de la présente invention est de remédier à au moins un de ces inconvénients.

Un autre but de l'invention est de proposer une solution de dissipation thermique plus efficace pour un composant électronique recouvert d'un blindage électromagnétique.

Un autre but de l'invention est de proposer une solution de dissipation thermique pour un composant électronique recouvert d'un blindage électromagnétique qui s'adapte aux tolérances de fabrication tout réalisant une dissipation thermique plus efficace que les solutions connues.

### Exposé de l'invention

L'invention propose d'atteindre au moins l'un des buts précités par une carte électronique comprenant :
- un support,
- au moins un composant électronique monté sur ledit support,
- une couche de protection, montée sur ledit support à une distance non nulle dudit composant électronique et recouvrant ledit composant électronique, et
- un dispositif de dissipation thermique pour ledit composant électronique ;
caractérisé en ce que ledit dispositif de dissipation thermique comprend une pièce de liaison thermique, métallique, vissée dans ladite couche de protection, traversant ladite couche de protection et venant au contact dudit composant électronique, de sorte à créer une liaison thermique entre ledit composant électronique et ladite couche de protection.

Ainsi, l'invention propose une pièce de liaison thermique qui est réalisée en métal. Une telle pièce métallique à une meilleure conduction thermique comparée à la mousse thermique utilisée dans les solutions connues, ce qui permet d'améliorer la liaison thermique entre le composant et la couche de protection, et donc une meilleure dissipation thermique.

De plus, l'invention propose une pièce de liaison thermique qui est vissée dans la couche de protection. Ainsi, il est possible d'ajuster la position de ladite pièce de liaison thermique en fonction de la hauteur à laquelle se trouve le composant électronique une fois montée sur la carte électronique, et donc de s'adapter aux différences de hauteur dudit composant électronique dues aux tolérances de fabrication de la carte électronique.

Au moins pour ces raisons, l'invention propose une solution de dissipation thermique qui s'adapte aux tolérances de fabrication tout en réalisant une dissipation thermique plus performante pour un composant électronique recouverte d'une couche de protection, telle qu'une couche de blindage électromagnétique.

De plus, utilisation d'une pièce de liaison thermique vissée dans la couche de protection permet de ne pas perturber la protection apportée par la couche de protection car le vissage permet de garder le contact entre la pièce de transfert thermique et la couche de protection, et donc la protection réalisée, en particulier dans le cas où la couche de protection réalise un blindage électromagnétique.

Le composant électronique peut être tout type de composant électronique monté, et en particulier soudé, sur une carte électronique. Par exemple, le composant électronique peut être une puce électronique, une FPGA, une puce mémoire, un processeur, un composant électrique, un composant de traitement de signal, un composant d'électronique de puissance, etc.

Le support sur lequel est monté, en particulier soudé, l'au moins un composant électronique peut être tout type de support, et en particulier un circuit imprimé, ou PCB.

Suivant des modes de réalisation, la pièce de liaison thermique peut être une vis.

Suivant des modes de réalisation, la pièce de liaison thermique peut comporter une surface plate au niveau de son extrémité venant au contact du composant électronique.

Ainsi, la surface de contact entre le composant électronique et la pièce de liaison thermique est augmentée, ce qui permet d'améliorer la dissipation thermique de la chaleur générée par ledit composant électronique.

Suivant des modes de réalisation, la pièce de liaison thermique peut comprendre, du côté opposé à son extrémité venant au contact du composant électronique, un moyen pour visser et dévisser ladite pièce de liaison thermique, en particulier à l'aide d'un outil.

Un tel moyen de manipulation peut par exemple être prévu pour recevoir un outil, par exemple un tournevis ou similaire, pour visser la pièce de liaison thermique dans la couche de protection.

Un tel moyen de manipulation peut être mâle ou femelle.

En particulier, un tel moyen manipulation peut être une encoche, ou un évidement, prévu(e) sur la pièce de liaison du côté de son extrémité opposée à celle venant au contact du composant électronique.

Suivant des modes de réalisation, la pièce de liaison thermique peut comprendre, du côté opposé à son extrémité venant au contact du composant électronique, un moyen pour bloquer ladite pièce en rotation après sa mise en place.

Un tel moyen permet ainsi de s'assurer que la pièce de liaison thermique reste en position, et ne dévisse pas, dans le temps. Ainsi, on s'assure du maintien dans le temps du contact entre la pièce de liaison thermique et le composant électronique, et donc de la dissipation thermique.

Un tel moyen de blocage en position peut être mâle ou femelle.

En particulier, un tel moyen de blocage peut être, ou comprendre, au moins une encoche prévue pour recevoir une colle, ou un vernis, déposé(e) dans ladite encoche et débordant sur la couche de protection, permettant ainsi de bloquer en rotation la pièce de liaison thermique.

Par exemple, l'au moins une encoche peut être prévue sur une périphérie de la pièce de liaison, par rapport à l'axe de rotation de ladite pièce de liaison thermique.

Suivant des modes de réalisation, la pièce de liaison thermique peut être réalisée en cuivre, en aluminium, en acier, en laiton, en titan, en bronze, ou en tout autre matériau métallique ayant une conduction thermique suffisante pour dissiper la chaleur du composant électronique.

La couche de protection peut être réalisée en tout matériau adapté à la fonction de protection réalisée par ladite couche de protection.

Suivant des modes de réalisation, la couche de protection peut être en métal.

La couche de protection peut réaliser tout type de protection. Par exemple, la couche de protection peut réaliser une protection contre l'eau, contre la poussière, etc.

Suivant des modes de réalisation, la couche de protection peut être une couche de blindage électromagnétique. Dans ce cas, la couche de protection, également appelée couche de blindage, est réalisée en métal.

Suivant des modes de réalisation, la couche de protection peut être dédiée à un unique composant électronique de la carte selon l'invention.

Suivant des modes de réalisation, la couche de protection peut être commune à plusieurs composants électroniques, et en particulier à tous les composants électroniques de la carte électronique.

Lorsque la couche de protection est commune à plusieurs composants électroniques, la dissipation thermique peut être réalisée pour chacun de ces composants électroniques.

Alternativement, lorsque la couche de protection est commune à plusieurs composants électroniques, la dissipation thermique peut être réalisée pour certains, voire un seul, de ces composants électroniques.

Suivant des modes de réalisation, la carte selon l'invention peut comprendre au moins deux composants électroniques équipés d'une pièce de liaison thermique métallique individuelle.

Autrement dit, chacun de ces deux composants électroniques est équipé d'une pièce de liaison thermique individuelle et dédiée audit composant électronique. Ainsi, l'invention permet de réaliser une dissipation thermique efficace et dédiée à chaque composant électronique.

Suivant des modes de réalisation, la carte selon l'invention peut en outre comprendre un dissipateur thermique relié à la couche de protection et/ou à la pièce de liaison thermique. Dans ce cas, la dissipation thermique est réalisée par la pièce de liaison thermique, par la couche de protection et par le dissipateur thermique.

Le dissipateur thermique peut être commun à plusieurs composants, et en particulier à toute la carte électronique.

Suivant des modes de réalisation, la carte selon l'invention peut ne pas comprendre un dissipateur thermique. Dans ce cas, la dissipation thermique est réalisée par la pièce de liaison thermique et surtout par la couche de protection.

La carte électronique selon l'invention peut être une carte électronique pouvant être mise en oeuvre dans tous les domaines de l'électronique, dans tout appareil électronique, et dans tout type d'application.

Suivant des modes de réalisation, la carte électronique selon l'invention peut être utilisée dans une application, ou dans un appareil, radiofréquence.

Selon un autre aspect de l'invention, il est proposé un appareil électronique comprenant une carte électronique selon l'invention.

L'appareil électronique peut être tout type d'appareil.

En particulier, l'appareil électronique peut être un serveur, un calculateur, un ordinateur, une tablette, un téléphone, un appareil de goniométrie, un émetteur et en particulier un émetteur radiofréquence, un récepteur et en particulier un récepteur radiofréquence, une antenne, etc.

### Description des figures et modes de réalisation

D'autres avantages et caractéristiques apparaîtront à l'examen de la description détaillée de modes de réalisation nullement limitatifs, et des dessins annexés sur lesquels :
- les FIGURES 1a et 1b sont des représentations schématiques d'un exemple de réalisation d'une carte comportant une solution de dissipation thermique de l'art antérieur ;
- les FIGURES 2a et 2b sont des représentations schématiques d'un exemple de réalisation non limitatif d'une carte électronique selon l'invention ;
- la FIGURE 3 est une représentation schématique d'un autre exemple de réalisation non limitatif d'une carte électronique selon l'invention ; et
- les FIGURES 4a et 4b sont des représentations schématiques d'un exemple de réalisation non limitatif d'une pièce de liaison thermique pouvant être mise en oeuvre dans une carte électronique selon l'invention.

Il est bien entendu que les modes de réalisation qui seront décrits dans la suite ne sont nullement limitatifs. On pourra notamment imaginer des variantes de l'invention ne comprenant qu'une sélection de caractéristiques décrites par la suite isolées des autres caractéristiques décrites, si cette sélection de caractéristiques est suffisante pour conférer un avantage technique ou pour différencier l'invention par rapport à l'état de la technique antérieure. Cette sélection comprend au moins une caractéristique de préférence fonctionnelle sans détails structurels, ou avec seulement une partie des détails structurels si c'est cette partie qui est uniquement suffisante pour conférer un avantage technique ou pour différencier l'invention par rapport à l'état de la technique antérieure.

En particulier toutes les variantes et tous les modes de réalisation décrits sont combinables entre eux si rien ne s'oppose à cette combinaison sur le plan technique.

Sur les figures et dans la suite de la description, les éléments communs à plusieurs figures conservent la même référence.

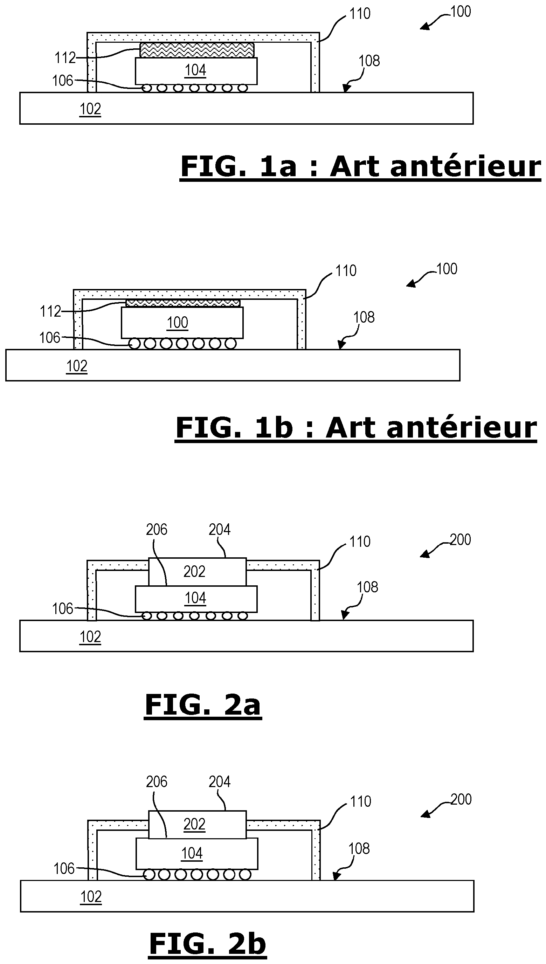

Les FIGURES 1a et 1b sont des représentations schématiques d'une carte électronique de l'art antérieur.

La carte électronique 100 représentée sur les FIGURES 1a et 1b comporte un support 102 sur lequel est monté au moins un composant électronique 104

Le support 102 peut être tout type de support pouvant recevoir des composants électroniques. En particulier, le support 102 est un circuit imprimé, ou PCB, communément utilisé dans la conception de cartes électroniques.

Le composant 104 peut être tout type de composant électronique, tel que par exemple une puce électronique, un processeur, une puce mémoire, un FPGA, etc.

Dans l'exemple représenté sur les FIGURES 1a et 1b, et sans parte de généralité, seul un composant électronique est représenté. Bien entendu, la carte électronique 100 peut comprendre, et comprend généralement, plusieurs composants électroniques.

Le composant électronique 104 peut être monté sur le support 102 de diverses manières. En particulier, le composant électronique 104 peut être soudé par un ou plusieurs joints de soudure 106 sur une face 108, appelée face avant dans la suite, du support 102.

La carte électronique 100 comprend en outre une couche de protection 110 recouvrant le composant électronique 104. Dans l'exemple représenté, la couche de protection 110 est représentée comme recouvrant un seul composant électronique. Bien entendu cela n'est nullement limitatif et la couche de protection 110 peut recouvrir, et recouvre généralement, plusieurs composants électroniques. Dans certains cas, la couche de protection 110 peut recouvrir tous les composants montés sur le support 102.

La couche de protection 110 recouvre totalement le composant électronique 104. En d'autres termes, la couche de protection 110 réalise un dôme ou une cloche ou encore un couvercle de protection, tout autour du composants électronique 104. Suivant encore d'autres termes, la couche de protection 110 délimite une chambre de protection fermée tout autour du composant électronique 104 du côté de la face avant 108 du support 102.

La couche de protection 110 peut réaliser tout type de protection : protection contre l'eau, l'air, la poussière, etc. La couche de protection est réalisée en un matériau qui convient à la fonction de la couche de protection, par exemple en plastique, en métal, etc.

Dans la suite, sans perte de généralité, la couche de protection 110 réalise un blindage électromagnétique pour le composant électronique 104, et peut être appelée couche de blindage 110. La couche de blindage 110 est réalisée en métal.

Lorsque le composant électronique 104 est en fonctionnement, il chauffe. Pour éviter qu'il surchauffe, il est nécessaire de dissiper la chaleur qu'il génère, sous peine de dysfonctionnement, voire de dégradation, dudit composant, conduisant à un arrêt de fonctionnement dudit composant 104.

Or, le composant électronique 104 est entouré par une couche de blindage 110. Ainsi, pour dissiper la chaleur du composant électronique 104, il faut créer une liaison thermique entre le composant électronique 104 et la couche de blindage 110 et éventuellement un dissipateur thermique (non représenté sur les FIGURES 1a et 1b). Une telle liaison thermique permettra une conduction de la chaleur du composant électronique 104, vers la couche de protection 110 (et éventuellement vers le dissipateur thermique) qui assurera la dissipation de ladite chaleur, par exemple vers l'air ambiant.

Du fait des tolérances de fabrication liées :
- à la hauteur du composant électronique 104,
- à la hauteur des joints de soudage 106, et/ou
- à la hauteur de la couche de protection 110 ;
il n'est pas, ou extrêmement difficile de réaliser la liaison thermique par une pièce métallique insérée entre le composant électronique 104 et la couche de blindage 110. Pour faire face à cette problématique, la solution actuellement connue met en oeuvre une mousse thermique 112 entre le composant électronique 104 et la couche de blindage 110. Cette mousse thermique 112 est compressible et permet d'absorber les tolérances de fabrication, comme on le voit dans la configuration représentée sur la FIGURE 1b où elle est compressée plus que la configuration représentée sur la FIGURE 1a.

Cependant, cette solution présente des inconvénients importants. Un inconvénient majeur consiste dans le fait que la mousse thermique 112 présente une faible conduction thermique ce qui ne permet de pas de dissiper la chaleur du composant électronique 104 de manière satisfaisante. D'autre part, lorsque la couche de protection 110 n'est pas métallique, cette solution ne permet pas une dissipation thermique.

L'invention propose de remédier au moins à ces inconvénients.

Les FIGURES 2a et 2b sont des représentations schématiques d'une carte électronique selon l'invention.

La carte électronique 200 représentée sur les FIGURES 2a et 2b comprend tous les éléments de la carte électronique 100 des FIGURES 1a et 1b, ainsi que toutes les alternatives décrites pour ces éléments, à l'exception de la mousse thermique 112.

A la différence de la carte 100, la carte électronique 200 comprend une pièce de liaison thermique 202 entre le composant électronique 104 et la couche de protection 110.

La pièce de liaison thermique 202 est réalisée en métal, et en particulier en cuivre, et permet de réaliser une bonne conduction thermique.

De plus, la pièce de liaison thermique 202 est vissée dans la couche de blindage 110. Ainsi, la pièce de liaison thermique 202 a une surface de contact avec la couche de blindage s'étendant sur toute l'épaisseur de la couche de blindage 110, ce qui permet un transfert de chaleur efficace vers ladite couche de blindage 110.

Surtout, comme la pièce de liaison thermique 202 est vissée dans la couche de blindage 110, cela permet d'ajuster la position de la pièce de liaison thermique 202 à la hauteur du composant électronique 104 après que ce dernier est monté sur le support 102, et donc d'absorber les tolérances de fabrication. Ainsi, dans la configuration représentée sur la FIGURE 2b la pièce de liaison thermique 202 se trouve dans une position plus haute comparée à la configuration représentée sur la FIGURE 2a.

Dans tous les cas, la pièce de liaison 202 peut être suffisamment vissée, par exemple par son extrémité 204, dite extrémité proximale, pour venir au contact du composant électronique 104, au niveau d'une extrémité 206, appelée extrémité distale, opposée à l'extrémité proximale 204. De plus, la pièce de liaison thermique 202 est mise en place, et ajustée, après que le composant électronique 104 et la couche de blindage 110 sont montés sur le support 102. Cela permet une mise en oeuvre simplifiée comparée à la solution actuelle.

L'extrémité distale 206 venant au contact du composant électronique 104, et en particulier contre une face supérieure du composant électronique 104, peut comporter une surface plate permettant d'augmenter la surface de contact entre le composant électronique 104 et la pièce de liaison thermique 202, et donc d'augmenter le transfert de la chaleur du composant électronique 104 vers la pièce de liaison 202, et donc vers la couche de protection 110 et/ou un dissipateur thermique (non représenté) équipant la carte électronique 200.

De plus, la pièce de liaison thermique 202 peut, au besoin, être directement reliée à un dissipateur thermique (non représenté), par exemple par, ou au niveau de, son extrémité proximale 204. Ainsi, si la couche de protection (ou la couche de blindage) 110 ne réalise pas de dissipation thermique, ou une dissipation thermique suffisante, un dissipateur thermique peut être relié à la pièce de liaison thermique 202 directement.

Ainsi, la solution proposée permet une meilleure dissipation thermique du composant électronique 104, tout en s'ajustant aux tolérances de fabrication et de montage du composant électronique 104 et/ou de la couche de protection 110.

La pièce de liaison thermique 202 peut se présenter sous toute forme.

La pièce de liaison thermique 202 peut comporter un moyen de vissage (non représenté sur les FIGURES 2a et 2b), telle qu'une encoche ou un évidement, permettant de la visser et de la dévisser, en particulier à l'aide d'un outil de type tournevis ou similaire.

La pièce de liaison thermique 202 peut comporter un moyen de blocage en position (non représenté sur les FIGURES 2a et 2b), telle qu'une encoche ou un évidement prévu pour recevoir une colle ou un vernis la reliant à la couche de protection 110, une fois montée et ajustée.

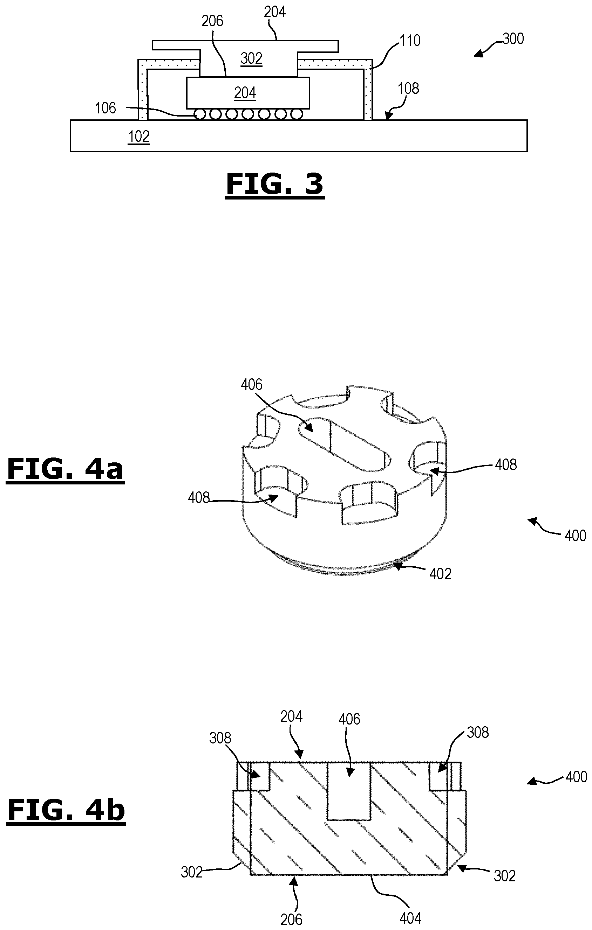

La FIGURE 3 est une représentation schématique d'un autre exemple de réalisation non limitatif d'une carte électronique selon l'invention.

La carte électronique 300 représentée sur la FIGURE 3 comprend tous les éléments de la carte 200 représentée sur les FIGURES 2a et 2b, à la différence de la pièce de liaison thermique 202.

La carte électronique 300 comporte une pièce de liaison thermique 302 présentant toutes les caractéristiques de la pièce de liaison thermique 202, sauf du côté de son extrémité proximale 204. En effet, la pièce de liaison thermique 302 comporte une largeur plus importante du côté de son extrémité proximale 204, comparé au reste de ladite pièce, et permettant d'améliorer la dissipation thermique.

Bien entendu, les modes de réalisation décrits sont des exemples non limitatifs donnés à titre d'illustration. La pièce de liaison thermique peut présenter d'autres formes que celles représentées sur les FIGURES 2a-2b et la FIGURE 3.

Les FIGURES 4a et 4b sont des représentations schématiques d'un exemple de réalisation non limitatif d'une pièce de liaison thermique pouvant être mise en oeuvre dans une carte électronique selon l'invention.

La pièce de liaison thermique 400 des FIGURES 4a et 4b peut être mise en oeuvre dans toute carte électronique selon l'invention, et en particulier dans la carte électronique 200 des FIGURES 2a et 2b, ou dans la carte électronique 300 de la FIGURE 3.

La pièce de liaison thermique 400 est représentée sur la FIGURE 4a selon une vue isométrique, et sur la FIGURE 4b selon une vue en coupe réalisée le long de l'axe de montage (vissage/dévissage) de ladite pièce.

La pièce de liaison thermique 400 représentée sur les FIGURES 4a et 4b peut être la pièce de liaison thermique 202 des FIGURES 2a et 2b, ou la pièce de liaison thermique 302 de la FIGURE 3.

Dans l'exemple non limitatif représenté sur les FIGURES 4a et 4b, la pièce de liaison thermique 400 se présente sous la forme générale d'une vis, avec une section générale cylindrique.

La pièce de liaison thermique 400 comporte une section filetée 402. Cette section filetée 402 permet de visser la pièce de liaison thermique 400 dans un taraudage prévu à cet effet dans la couche de protection positionnée au dessus du composant électronique Dans l'exemple non limitatif représenté, la section filetée 402 est plus proche de l'extrémité distale 206 de la pièce de liaison thermique 400 prévue pour venir au contact du composant électronique..

La pièce de liaison thermique 400 comporte, du côté de son extrémité distale 206, une surface plate 404 prévue pour entrer en contact avec le composant électronique. Cette surface plate 404 est de préférence la plus large possible pour optimiser la liaison thermique entre la pièce 400 et le composant électronique.

La pièce de liaison thermique 400 comporte, du côté de son extrémité proximale 204, une encoche (ou un évidement) 406 prévue pour recevoir l'extrémité d'un tournevis, ou d'un outil similaire, pour visser ou dévisser ladite pièce 400 dans la couche de protection. Bien entendu, cet exemple de réalisation n'est nullement limitatif et d'autre moyen de vissage/dévissage peuvent être utilisés à la lace de l'encoche 406.

La pièce de liaison thermique 400 comporte, du côté de son extrémité proximale 204, une ou plusieurs encoches 408 utilisées pour bloquer en rotation ladite pièce 400 après mise en place et ajustement. En particulier, un filet de vernis, de colle, ou de tout autre matériau durcissant ou collant, est déposé(e) dans une ou plusieurs encoches 408 et sur la couche de protection. En durcissant ce matériau créé une liaison mécanique entre la pièce de thermique 400 et la couche de protection, s'opposant à la rotation de la pièce de liaison thermique 400 ce qui maintient ladite pièce de liaison thermique 400 en place et au contact du composant électronique. Bien entendu, cet exemple de réalisation n'est nullement limitatif et d'autre moyen de blocage en position peuvent être utilisés à la place des encoches 408. Par exemple, la pièce de liaison thermique peut être soudée à la couche de protection, après sa mise en place.

Bien entendu l'invention n'est pas limitée aux exemples qui viennent d'être décrits.

## Revendications

1. Carte électronique (200;300) comprenant :
- un support (102),
- au moins un composant électronique (104) monté sur ledit support (102),
- une couche de protection (110), montée sur ledit support (102) à une distance non nulle dudit composant électronique (104) et recouvrant ledit composant électronique (104), et
- un dispositif de dissipation thermique pour ledit composant électronique (104) ;
**caractérisé en ce que** le dispositif de dissipation thermique comprend une pièce de liaison thermique (202;302;400), métallique, vissée dans ladite couche de protection (110), traversant ladite couche de protection (110) et venant au contact dudit composant électronique (104), de sorte à créer une liaison thermique entre ledit composant électronique (104) et ladite couche de protection (110).

2. Carte (200;300) selon la revendication précédente, **caractérisée en ce que** la pièce de liaison thermique (202;302;400) est une vis.

3. Carte (200;300) selon l'une quelconque des revendications précédentes, **caractérisée en ce que** la pièce de liaison thermique (202;302;400) comporte une surface plate au niveau de son extrémité (206) venant au contact du composant électronique (104).

4. Carte (200;300) selon l'une quelconque des revendications précédentes, **caractérisée en ce que** la pièce de liaison thermique (400) comprend, du côté opposé à son extrémité (206) venant au contact du composant électronique (104), un moyen (406), et en particulier une encoche, pour visser et dévisser ladite pièce de liaison (400).

5. Carte (200;300) selon l'une quelconque des revendications précédentes, **caractérisée en ce que** la pièce de liaison thermique (400) comprend, du côté opposé à son extrémité (206) venant au contact du composant électronique (104), un moyen (408), et en particulier une encoche, pour bloquer ladite pièce (400) en rotation après sa mise en place.

6. Carte (200;300) selon l'une quelconque des revendications précédentes, **caractérisée en ce que** la pièce de liaison thermique (202;302;400) est réalisée en cuivre, en aluminium, en acier, en laiton, en titan, en bronze.

7. Carte (200;300) selon l'une quelconque des revendications précédentes, **caractérisée en ce que** la couche de protection (110) est en métal.

8. Carte (200;300) selon l'une quelconque des revendications précédentes, **caractérisée en ce que** la couche de protection (110) est une couche de blindage électromagnétique.

9. Carte (200;300) selon l'une quelconque des revendications précédentes, **caractérisée en ce que** la couche de protection (110) est commune à plusieurs composants électroniques.

10. Carte selon l'une quelconque des revendications précédentes, **caractérisée en ce qu'**elle comprend au moins deux composants électroniques équipés d'une pièce de liaison thermique métallique individuelle.

11. Carte selon l'une quelconque des revendications précédentes, **caractérisée en ce qu'**elle comprend en outre un dissipateur thermique relié à la couche de protection et/ou à la pièce de liaison thermique.

12. Carte (200;300) selon l'une quelconque des revendications précédentes, **caractérisée en ce qu'**elle utilisée dans une application, ou dans un appareil, radiofréquence.

13. Appareil électronique comprenant une carte électronique (200;300) selon l'une quelconque des revendications précédentes.
